(19) Europäisches Patentamt
European Patent Office
Office européen des brevets

(11) **EP 3 676 967 B1**

(12) **FASCICULE DE BREVET EUROPEEN**

(45) Date de publication et mention
de la délivrance du brevet:
**12.05.2021 Bulletin 2021/19**

(21) Numéro de dépôt: **18758904.9**

(22) Date de dépôt: **30.08.2018**

(51) Int Cl.:
*H04B 7/06* *(2006.01)*  *H01Q 3/10* *(2006.01)*
*H01Q 3/26* *(2006.01)*

(86) Numéro de dépôt international:
**PCT/EP2018/073384**

(87) Numéro de publication internationale:
**WO 2019/043117 (07.03.2019 Gazette 2019/10)**

(54) **PROCÉDÉ ET DISPOSITIF D'ESTIMATION DU DÉPOINTAGE D'UNE ANTENNE ET PROCÉDÉ ET DISPOSITIF DE POURSUITE DU POINTAGE D'UNE ANTENNE METTANT EN OEUVRE DE TELS PROCÉDÉ ET DISPOSITIF, FONDÉS SUR UNE ANALYSE HARMONIQUE**

VERFAHREN UND VORRICHTUNG ZUR SCHÄTZUNG DES WINKELFEHLERS EINER ANTENNE UND VERFAHREN UND VORRICHTUNG ZUR VERFOLGUNG DER AUSRICHTUNG EINER ANTENNE ZUR DURCHFÜHRUNG EINES SOLCHEN VERFAHRENS UND VORRICHTUNG, BASIEREND AUF EINER HARMONISCHEN ANALYSE

METHOD AND DEVICE FOR ESTIMATING THE SQUINT OF AN ANTENNA AND METHOD AND DEVICE FOR FOLLOWING THE POINTING OF AN ANTENNA IMPLEMENTING SUCH A METHOD AND DEVICE, BASED ON A HARMONIC ANALYSIS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.08.2017 FR 1758000**

(43) Date de publication de la demande:
**08.07.2020 Bulletin 2020/28**

(73) Titulaire: **Safran Data Systems**
**91978 Courtaboeuf Cedex (FR)**

(72) Inventeur: **VARIERAS, François**
**14740 Bretteville L'Orgueilleuse (FR)**

(74) Mandataire: **Regimbeau**
**20, rue de Chazelles**
**75847 Paris Cedex 17 (FR)**

(56) Documents cités:
**EP-A1- 0 507 440    US-A- 2 638 585**
**US-A- 5 093 649**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

DOMAINE TECHNIQUE GENERAL

L'invention concerne un procédé et un dispositif d'estimation précis du dépointage angulaire d'une antenne de réception de télécommunications. Cette information permet essentiellement de prendre une décision relative au respect de normes relatives au rayonnement hors axe quand l'antenne est aussi émettrice.

ETAT DE LA TECHNIQUE

Les stations de télécommunications au sol sont en communication avec des dispositifs mobiles tels que des satellites par l'intermédiaire d'une antenne. Cette antenne doit être correctement pointée vers le mobile pour assurer une bonne qualité de communication sans perturber les autres utilisateurs travaillant dans la même bande de fréquence sur le lien montant.

Au cours de la communication, le mobile peut dériver, ou bien le porteur sur lequel est assise l'antenne peut être mobile et soumis à des mouvements de sorte que l'antenne n'est plus correctement pointée vers le mobile.

Outre la dégradation de la communication un tel dépointage peut entrainer la réception de signaux non désirés ou bien perturber les communications relayées par des dispositifs de communication adjacents ou bien des satellites adjacents quand l'antenne est aussi émettrice.

Aussi, il existe des solutions pour, d'une part estimer le dépointage de l'antenne et, pour d'autre part, repointer l'antenne correctement afin de compenser le dépointage estimé. Dans ce dernier cas, on parle alors de poursuite du pointage ou d'écartométrie constituée sous la forme d'une boucle d'asservissement.

La mesure de dépointage angulaire la plus populaire et la moins chère se fait par une technique dite de « Step-Track » ou « Track While Scan ». A ce titre, on pourra se référer aux documents US 6 433 736 et US 7 633 432.

Cette technique comprend l'application à l'antenne d'un mouvement prédéfini de dépointage de faible amplitude (en anglais, « dithering movement ») autour de la direction anticipée de l'émetteur (le satellite ou le mobile). Un récepteur mesure la variation de niveau de signal reçu au long de cette trajectoire et, selon son profil, estime une grandeur proportionnelle à l'angle de dépointage par rapport à cette direction anticipée.

Dans ce cas, le récepteur le plus simple possible est dit « non cohérent » et calcule directement la puissance instantanée du signal reçu dans sa bande passante sans le démoduler.

Le problème est qu'une telle technique est très sensible au rapport signal-à-bruit, elle fournit notamment une réponse dont le facteur d'échelle ou gain (ratio de la réponse de puissance par le dépointage) dépend de cette valeur. On rencontre alors deux inconvénients majeurs pour les systèmes d'antenne intégrant cette solution.

Le premier est qu'on ne sait pas déterminer si on a dépassé l'erreur de pointage maximale autorisée réglementairement pour pouvoir émettre. L'équipement pourrait alors se voir refuser les certifications requises pour être diffusé sur le marché.

Le second est que l'on commet une erreur importante de synthèse de la fonction de transfert pour la boucle d'asservissement de la poursuite. Au mieux, la bande passante de poursuite s'en trouve très réduite (gain plus faible qu'estimé), au pire la poursuite devient carrément instable et l'équipement est inutilisable (gain plus fort qu'estimé).

Ces difficultés sont de plus en plus critiques car les nouvelles techniques de communication (à étalement de spectre, à codage de l'information de plus en plus sophistiqué) exigent de pouvoir fonctionner avec des rapports signaux-à-bruit très faibles voire négatifs (exprimés en décibels). Dans ce cas, la valeur S / (S+N) s'écarte fortement de 1 et le gain s'en retrouve très fortement réduit.

La demande de brevet US 2 638 585 A divulgue un exemple d'un procédé d'estimation du dépointage. Dans cette estimation, une analyse est faite sur l'harmonique d'un signal reçu en utilisant le rapport entre un terme fondamental et un terme harmonique.

PRESENTATION DE L'INVENTION

L'invention propose de pallier les inconvénients précités.

A cet effet, selon un premier aspect, l'invention propose un procédé d'estimation du dépointage angulaire x d'une antenne pointant vers un satellite ou un mobile éloigné selon un axe d'antenne, l'antenne étant en communication radio avec ce satellite ou ce mobile le satellite ou le mobile émettant sur une porteuse continue modulée en amplitude/phase par un mssage, dans une bande de fréquence donnée, le procédé comprenant des étapes suivantes :

- application d'un mouvement périodique prédéfini à l'axe d'antenne ;
- réception de signaux radiofréquences issus du satellite ou du mobile, pendant une durée qui correspond à une période du mouvement appliqué, le signal étant reçu sur une bande de fréquence inférieure ou égale à la fréquence du signal émis ;

- détermination sur une échelle logarithmique de la puissance instantanée du signal reçu, ladite puissance instantanée étant obtenue au moyen des étapes suivantes :

- filtrage du signal en fréquence intermédiaire ou en bande de base de tout ou partie du spectre du signal parvenant du satellite ou du mobile

- calcul de la tension efficace du signal radiofréquence reçu ;

- filtrage de cette tension efficace ;

- calcul du logarithme de cette tension efficace filtrée ;

- décomposition harmonique sur chaque période de la puissance ainsi déterminée en une composante fondamentale et au moins une composante harmonique ;
- estimation du dépointage angulaire x définit par le rapport de la composante fondamentale sur une composante harmonique.

L'invention est avantageusement complétée par les caractéristiques suivantes, prises seules ou en une quelconque de leur combinaison techniquement possible.

La composante harmonique d'intérêt est la composante harmonique 2 (H2), l'estimation du dépointage angulaire x étant obtenu à partir du ratio de la composante fondamentale sur la composante harmonique 2.

Le mouvement est de type sinusoïdal ou composition 2D de mouvements élémentaires sur 2 axes orthogonaux de types sinusoïdaux de préférence elliptiques ou Lissajous.

Selon un deuxième aspect, l'invention se rapporte à un procédé de poursuite du pointage d'une antenne, une étape de mesure du dépointage angulaire de l'antenne au moyen d'un procédé d'estimation selon l'invention, ledit procédé comprenant une étape de

- comparaison du dépointage à un seuil, et
- si le dépointage est supérieur au dit seuil, le procédé comprenant une étape d'arrêt de l'émission de l'antenne vers le satellite ou le mobile si l'antenne est aussi

émettrice.

Le procédé selon le deuxième aspect de l'invention peut comprendre une étape de comparaison de l'harmonique 2 à deux valeurs de seuils, et si ladite harmonique 2 est comprise entre lesdites deux valeurs de seuil, le procédé comprend une étape de génération d'une consigne de déplacement de l'antenne pour annuler le dépointage estimé.

Selon un troisième aspect, l'invention concerne un dispositif de mesure précise de l'erreur de pointage angulaire d'une antenne comprenant un processeur configuré pour mettre en œuvre un procédé selon le premier aspect de l'invention.

Selon un quatrième aspect, l'invention concerne un dispositif de poursuite du pointage d'une antenne comprenant une unité de commande de l'antenne et un dispositif d'estimation du dépointage angulaire de l'antenne selon le troisième aspect de l'invention et comprenant un processeur configuré pour mettre en œuvre un procédé selon le deuxième aspect de l'invention.

## PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :

- la figure 1 illustre un schéma contextuel de l'invention comprenant un dispositif de poursuite pointage d'une antenne ;
- la figure 2 illustre des étapes de procédé de détermination du pointage de l'antenne selon l'invention

Sur l'ensemble des figures les éléments similaires portent des références identiques.

## DESCRIPTION DETAILLEE DE L'INVENTION

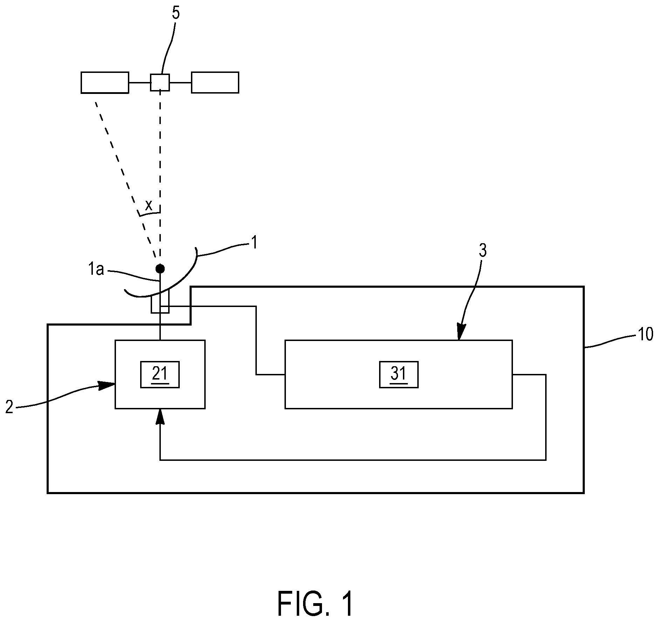

La **figure 1** illustre un système de poursuite du pointage d'une antenne 1 vers un dispositif mobile de communication, par exemple un satellite S. Le satellite S est typiquement géostationnaire et est typiquement un satellite de télécommunication.

Le mobile de communication ou satellite S émet avantageusement un signal radio sur une porteuse continue (c'est-à-dire tel que sa puissance d'émission soit constante) modulée en amplitude/phase par un message aléatoire, dans une bande de fréquence donnée.

L'antenne 1 appartient à une station sol de type connue.

On considère que l'antenne 1 pointe vers le satellite S selon un axe 1a d'antenne. L'axe 1a d'antenne forme un angle x avec le satellite S. Cet angle x est le dépointage angulaire de l'antenne 1. L'axe 1a de l'antenne est typiquement défini comme la direction dans le repère antenne où le gain de cette dernière est maximum.

L'axe 1a d'antenne est motorisé par un moteur 2 qui reçoit des consignes d'un dispositif 3 de détermination du pointage de l'antenne.

Le dispositif 3 de détermination du pointage de l'antenne 1 est capable d'estimer un dépointage angulaire de l'antenne à partir duquel une consigne de pointage de l'antenne est générée pour être communiquée au moteur 21.

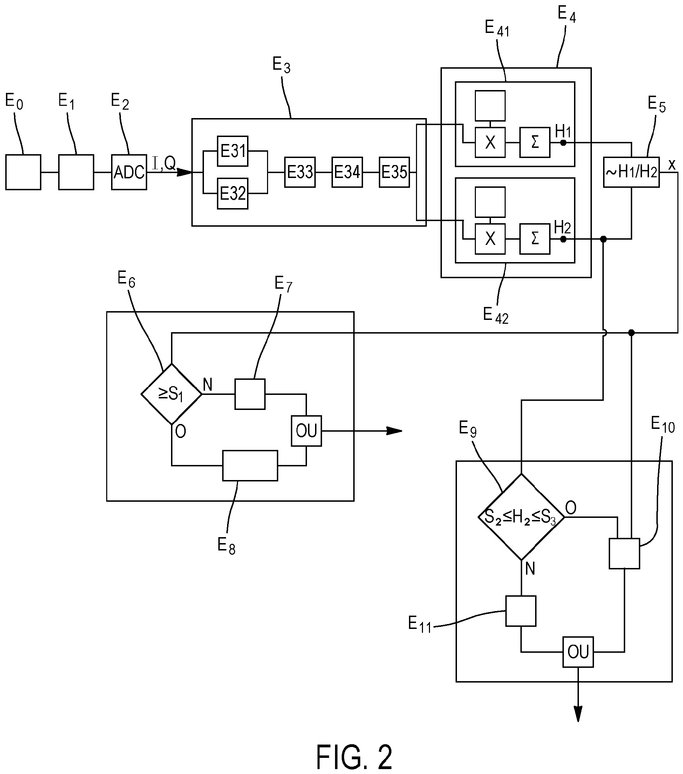

Un tel dispositif de mesure comprend un processeur 31 configuré pour mettre en œuvre un procédé d'estimation du dépointage et un procédé de poursuite du pointage décrits en relation avec la **figure 2.**

Dans une étape préliminaire (étape E0) un mouvement de dépointage périodique et de cinématique maîtrisée est appliqué à l'axe 1a d'antenne par l'intermédiaire d'une unité 2 de commande de l'antenne comprenant un moteur 21. Cette trajectoire périodique a une amplitude x1 et une pulsation $\omega$.

Il peut s'agit d'un mouvement sinusoïdal, ellipsoïdal, etc.

L'antenne 1 reçoit (étape E1) des signaux radio fréquences. Les signaux sont reçus pendant une durée qui correspond à la période du mouvement de dépointage.

En outre, le signal est reçu sur une bande de fréquences inférieure ou égale à la fréquence du signal émis par le mobile. Ceci permet de récupérer plus facilement le signal puisque le spectre de fréquences correspond à celui de l'émission.

Ces signaux reçus sont convertis (étape E2) en signaux complexes de composantes réelles et imaginaires respectivement I et Q, numériques, en bande de base.

Ensuite, un prétraitement (étape E3) des signaux I et Q est effectué. A l'issue de cette étape de prétraitement, la puissance instantanée du signal est obtenue.

Ce prétraitement comprend un filtrage en bande de base identique de chaque voie I & Q (étapes E31 et E32), de largeur inférieure ou égale à celle des signaux reçus, puis une mesure de la tension efficace instantanée (étape E33), puis un filtrage vidéo (étape E34) en bande étroite et enfin un calcul (étape E35) de la puissance du signal définie dans une échelle logarithmique est effectué à partir de cette tension efficace.

La puissance instantanée en décibels est fonction du logarithme de la tension efficace correspondant à une constante près au logarithme de la puissance logarithmique (E35) de la tension efficace filtrée :

$$\text{Puissance instantanée} = 20.\log(\text{tension efficace}) = 10.\log(\text{puissance}) + \text{constante.}$$

Le filtrage bande étroite est mis en œuvre au moyen d'un filtre ayant une fréquence de coupure Fc, Fc valant typiquement la dizaine de Hertz à quelques centaines de Hertz (typiquement 100 Hz).

Une décomposition harmonique de la puissance ainsi obtenue est ensuite effectuée (étape E4) de manière à obtenir une composante fondamentale H1 et au moins une composante harmonique 2 d'intérêt notée H2, voire une composante continue notée H0.

La décomposition harmonique s'effectue en calculant des produits de corrélation sur une période entre la puissance détectée et l'harmonique correspondante du mouvement de dépointage.

La composante continue H0 est donc obtenue en calculant la moyenne du signal obtenu en bout de la chaîne E3 sur une période du cycle de dépointage. Cette moyenne est représentative de la puissance moyenne de signal reçue du mobile.

La composante fondamentale H1 est obtenue en calculant sur une période le produit de corrélation (étape E41) entre le signal obtenu en bout de chaîne E3 et la fonction ayant régi le mouvement de l'antenne autour de la direction anticipée.

Dans le cas d'un mouvement sinusoïdal appliqué à l'antenne la corrélation se fait avec la fonction $x1.\sin(\omega(t))$.

La composante harmonique 2 H2 est obtenue en calculant le produit de corrélation (étape E42) entre la puissance du signal et la fonction $\cos(2.\omega(t))$.

Il est possible d'estimer en plus les harmoniques d'ordres supérieures comme H3, H4, etc..., ce qui permet potentiellement d'affiner les précisions de calcul de dépointage menés à l'étape suivante.

Ensuite, on estime l'erreur angulaire x (étape E5) à partir des valeurs de H0, H1 et H2, voire H3 ou un ordre supérieur, dont on a préalablement établi les valeurs par un calcul analytique en fonction de l'erreur x, de l'amplitude

de dépointage périodique $x_1$, de la largeur du lobe d'antenne à -3dB $x_0$ et du rapport signal à bruit dans la bande de base S/N.

En particulier, ces calculs montrent que le rapport des composantes H1/H2 constitue un estimateur <x> de l'erreur x indépendant de la valeur de rapport du signal à bruit et de la largeur du lobe, ce qui fournit la réalisation la plus simple de l'étape d'estimation E5.

Cet estimé <x> peut être comparée à un seuil S1 (étape E6). Si le dépointage angulaire est supérieur ou égal à ce seuil S1 alors on commande (étape E8) l'arrêt de l'émission de l'antenne vers le mobile ou le satellite si cette dernière est émettrice. Sinon l'émission continue (étape E7). Ces décisions sont communiquées à l'unité de commande de l'antenne 2.

De manière alternative ou complémentaire, l'harmonique 2 H2 peut être comparée à deux seuils S2 et S3 (étape E9). Si l'harmonique 2 H2 est comprise entre les deux seuils (c'est-à-dire S2 ≤ H2 ≤ S3) alors une consigne de re-pointage -<x> est déterminée (étape E10). Dans le cas contraire, aucune compensation n'est effectuée (étape E11). Là encore ces décisions sont communiquées à l'unité de commande de l'antenne 2.

La consigne permet de compenser le dépointage angulaire calculé pour que l'antenne pointe correctement vers le satellite.

Ci-dessous on démontre que le ratio $x/x_1$ est proportionnel au quotient des composantes fondamentale 1 et harmonique 2, relié à ce quotient par une constante fixe ne dépendant que de l'amplitude du mouvement effectué indépendante du rapport signal à bruit.

Soit une antenne 1 ayant des dimensions supérieures à 10.λ (avec λ la longueur d'onde des signaux radiofréquences reçus par l'antenne).

L'antenne possède un gain d'antenne :

$$G(dB) = G_0(dB) - 12{,}04 \left(\frac{x}{x_0}\right)^2 = G_0(dB) + 10 * \log\left[\exp\left(-2.77 * \left(\frac{x}{x_0}\right)^2\right)\right]$$

avec X=x + x1. sin($\omega$(t)) (décrivant la trajectoire totale de l'antenne).

En considérant un mouvement périodique d'équation x1. sin $\omega$(t) appliqué à l'antenne 1 (l'antenne étant soumise à un mouvement x1. sin $\omega$(t) + x) on a

$$G(dB) = G_0(dB) - 12{,}04 \left(\frac{x + x1.\sin(\omega(t))}{x_0}\right)^2$$

En notant S comme la puissance moyenne de signal utile reçue par l'antenne pointée dans l'axe et N le bruit fixe recueilli dans toute la bande de base, on calcule la puissance moyenne du signal reçu (en décibels) W(dB) obtenue à l'issue de l'étape de pré-traitement (étape E2) qui est donnée par :

$$W(dB) = 10*\log(N + S*\exp(-2.77*[(x + x_1*\sin(\omega t))/x_0]^2))$$

$$W(dB) = Cte + 10*\log[1 + S/(S+N)*(\exp(-2{,}77*[(x + x_1*\sin(\omega t))/x_0]^2) - 1)]$$

Si S<N et si les mouvements d'antenne sont de faible amplitude autour de son axe on a alors l'approximation :

$$W(dB) \approx Cte + 10/M*S/(S+N)*(\exp(-2{,}77*[(x + x_1*\sin(\omega t))/x_0]^2) - 1)$$

$$W(dB) \approx Cte - 12.04*S/(S+N)*[(x + x_1*\sin(\omega t))/x_0]^2$$

$$W(dB) \approx Cte - 12.04*S/(S+N)*[x^2 + 2x*x_1*\sin(\omega t))/x_0 + x_1^2/x_0^2 \sin^2(\omega t)]$$

$$W(dB) = Cte' - 12.04*S/(S+N)*(x_1/x_0)^{2}*[2*x/x_1 * \sin(\omega t) - \cos(2\omega t)/2]$$

$$M = \ln(10) = 2,3$$

Soit l'expression du terme fondamental H1 donné par l'expression suivante

$$H_1 = -\frac{S}{S+N} \cdot 12,04 \cdot \frac{2 \cdot x \cdot x_1}{x_0^2}$$

L'harmonique 2 H2 est donnée par la corrélation de la puissance du signal reçu avec un terme cosinus calculé sur une période entre 0 et $2\pi$, soit :

$$H_2 = \frac{S}{S+N} \cdot 12,04 \cdot \frac{x_1^2}{2x_0^2}$$

On obtient alors le rapport :

$$\frac{H_1}{H_2} = -4 \frac{x}{x_1}$$

On constate que le rapport entre le fondamental et l'harmonique 2 est indépendant du rapport signal à bruit. On remarque aussi que le rapport est indépendant de l'échelle de conversion logarithmique utilisée (népérien, base 10, 2 ou autre...). En revanche, cette proportionnalité n'est plus exacte si l'on n'a pas exprimé les puissances H1 et H2 par une échelle logarithmique. La conversion logarithmique n'est donc pas ici utilisée selon une convention d'ingénieur mais bien parce que c'est un procédé qui permet d'obtenir une la valeur correcte de dépointage, sans qu'il y ait besoin de calibrage ni de détermination d'un gain de proportionnalité, ni de correction de défaut de linéarité.

Bien entendu, ces qualités demeurent valables pour tout type de trajectoire appliquée à l'antenne 1 présentant une périodicité, quels que soient la taille du lobe d'antenne, l'amplitude du mouvement de recherche x1, l'erreur axiale de pointage x.

L'estimateur <x> est donc défini par la fonctionnelle suivante :

$$<x> = -4 \cdot x_1 \cdot \frac{H_1}{H_2}$$

**Revendications**

1.  Procédé d'estimation du dépointage angulaire x d'une antenne (1) pointant vers un satellite ou un mobile éloigné (S) selon un axe d'antenne (1a), l'antenne étant en communication radio avec ce satellite ou ce mobile (S), le satellite ou le mobile émettant sur une porteuse continue modulée en amplitude/phase par un message, dans une bande de fréquence donnée, le procédé comprenant des étapes suivantes :

    - application (E0) d'un mouvement périodique prédéfini à l'axe d'antenne (1a) ;
    - réception (E1) de signaux radiofréquences issus du satellite ou du mobile pendant une durée qui correspond à une période du mouvement appliqué, le signal étant reçu sur une bande de fréquence inférieure ou égale à la fréquence du signal émis ;
    - détermination (E3) sur une échelle logarithmique de la puissance instantanée du signal reçu, ladite puissance instantanée étant obtenue au moyen des étapes suivantes :

        - filtrage du signal en fréquence intermédiaire ou en bande de base (E31, E32) de tout ou partie du spectre du signal parvenant du satellite ou du mobile;
        - calcul (E33) de la tension efficace du signal radiofréquence reçu;
        - filtrage (E34) de cette tension efficace ;
        - calcul du logarithme de cette tension efficace filtrée ;

- décomposition (E4) harmonique sur chaque période de la puissance ainsi déterminée en une composante fondamentale (H1) et au moins une composante harmonique ;
- estimation (E5) du dépointage angulaire x définit par le rapport de la composante fondamentale sur une composante harmonique.

2. Procédé selon la revendication 1, dans lequel la composante harmonique d'intérêt est la composante harmonique 2 (H2), l'estimation du dépointage angulaire x étant obtenu à partir du ratio de la composante fondamentale sur la composante harmonique 2.

3. Procédé selon l'une des revendications précédentes, dans lequel le mouvement est de type sinusoïdal ou composition 2D de mouvements élémentaires sur 2 axes orthogonaux de types sinusoïdaux de préférence elliptiques ou Lissajous.

4. Procédé de poursuite du pointage d'une antenne, comprenant une étape d'estimation du dépointage angulaire de l'antenne au moyen d'un procédé d'estimation selon l'une des revendications 1 à 3, le procédé comprenant une étape de comparaison (E6) du dépointage à un seuil (S1) ; et si le dépointage est supérieur au dit seuil, le procédé comprenant une étape d'arrêt (E7) de l'émission de l'antenne vers le satellite ou le mobile si l'antenne est aussi émettrice

5. Procédé de poursuite du pointage d'une antenne selon la revendication 4, comprenant une étape de comparaison (E9) de l'harmonique 2 (H2) à deux valeurs de seuils (S2, 3), et si ladite harmonique 2 (H2) est comprise entre lesdites deux valeurs de seuil, le procédé comprenant une étape de génération (E10) d'une consigne de déplacement de l'antenne pour annuler le dépointage estimé.

6. Dispositif de mesure précise du dépointage angulaire d'une antenne comprenant un processeur configuré pour mettre en œuvre un procédé selon l'une des revendications 1 à 3.

7. Dispositif de poursuite du pointage d'une antenne comprenant une unité (2) de commande de l'antenne (1) et un dispositif d'estimation du dépointage angulaire de l'antenne selon la revendication 8 comprenant un processeur configuré pour mettre en œuvre un procédé selon l'une des revendications 4 à 5.

**Patentansprüche**

1. Verfahren zur Schätzung des Winkelfehlers x einer Antenne (1), die entlang einer Antennenachse (1a) zu einem Satelliten oder einem entfernten Mobiltelefon (S) zeigt, wobei die Antenne in Funkkommunikation mit diesem Satelliten oder diesem Mobiltelefon (S) ist, wobei der Satellit oder das Mobiltelefon auf einem amplituden-/phasenmodulierten kontinuierlichen Träger durch eine Nachricht in einem gegebenen Frequenzband sendet, wobei das Verfahren die folgenden Schritte umfasst:

- Anwenden (E0) einer vordefinierten periodischen Bewegung auf die Antennenachse (1a);
- Empfangen (E1) von aus dem Satelliten oder dem Mobiltelefon stammenden Funkfrequenzsignalen während einer Dauer, die einem Zeitraum der angewandten Bewegung entspricht, wobei das Signal auf einem Frequenzband kleiner oder gleich der Frequenz des gesendeten Signals empfangen wird;
- Bestimmen (E3), auf einer logarithmischen Skala, der Momentanleistung des empfangenen Signals, wobei die Momentanleistung anhand der folgenden Schritte erhalten wird:

  - Filtern des Signals in Zwischenfrequenz oder in Basisband (E31, E32) des gesamten Spektrums des vom Satelliten oder Mobiltelefon übermittelten Signals oder eines Teils davon;
  - Berechnen (E33) der Effektivspannung des empfangenen Funkfrequenzsignals;
  - Filtern (E34) dieser Effektivspannung;
  - Berechnen des Logarithmus dieser gefilterten Effektivspannung;
  - Oberwellenzerlegung (E4) über jeden Zeitraum der so bestimmten Leistung in eine grundlegende Komponente (H1) und mindestens eine Oberwellenkomponente;
  - Schätzen (E5) des durch die Beziehung der grundlegenden Komponente zu einer Oberwellenkomponente definierten Winkelfehlers x.

2. Verfahren nach Anspruch 1, wobei die Oberwellenkomponente von Interesse die Oberwellenkomponente 2 (H2) ist, wobei die Schätzung des Winkelfehlers x aus dem Verhältnis der grundlegenden Komponente zur Oberwellenkomponente 2 erhalten wird.

3. Verfahren nach einem der vorstehenden Ansprüche, wobei die Bewegung vom Typ sinusförmig oder eine zweidimensionale Zusammensetzung von grundlegenden Bewegungen über 2 orthogonale Achsen von sinusförmigen, vorzugsweise elliptischen oder Lissajou-Figur-Typen ist.

4. Verfahren zur Verfolgung der Zeigerichtung einer Antenne, umfassend einen Schritt zum Schätzen des Winkelfehlers der Antenne anhand eines Verfahrens zur Schätzung nach einem der Ansprüche 1 bis 3, wobei das Verfahren einen Vergleichsschritt (E6) des Winkelfehlers mit einem Schwellenwert (S1) umfasst; und falls der Winkelfehler größer als der Schwellenwert ist, das Verfahren einen Anhalteschritt (E7) des Sendens der Antenne zum Satelliten oder dem Mobiltelefon umfasst, falls die Antenne auch Senderin ist.

5. Verfahren zur Verfolgung der Zeigerichtung einer Antenne nach Anspruch 4, umfassend einen Vergleichsschritt (E9) der Oberwelle 2 (H2) mit zwei Schwellenwerten (S2, S3), und falls die Oberwelle 2 (H2) zwischen den beiden Schwellenwerten enthalten ist, umfasst das Verfahren einen Generierungsschritt (E10) eines Verschiebungssollwerts der Antenne zum Annullieren des geschätzten Winkelfehlers.

6. Vorrichtung zur präzisen Messung des Winkelfehlers einer Antenne, die einen Prozessor umfasst, der konfiguriert ist, um ein Verfahren nach einem der Ansprüche 1 bis 3 umzusetzen.

7. Vorrichtung zur Verfolgung der Zeigerichtung einer Antenne, umfassend eine Steuerungseinheit (2) der Antenne (1) und eine Vorrichtung zur Schätzung des Winkelfehlers der Antenne nach Anspruch 8, umfassend einen Prozessor, der konfiguriert ist, um ein Verfahren nach einem der Ansprüche 4 bis 5 umzusetzen.

**Claims**

1. A method for estimating the angular misalignment x of an antenna (1) pointing towards a satellite or a remote mobile (S) along an antenna axis (1a), the antenna being in radio communication with this satellite or this mobile (S), the satellite or the mobile transmitting on a continuous amplitude/phase modulated carrier by a message, in a given frequency band, the method comprising the following steps:

   - application (E0) of a predefined periodic movement to the antenna axis (1a);
   - receiving (E1) of radiofrequency signals derived from the satellite or from the mobile for a duration which corresponds to a period of the applied movement, the signal being received on a frequency band lower than or equal to the frequency of the transmitted signal;
   - determination (E3), on a logarithmic scale, of the instantaneous power of the received signal, said instantaneous power being obtained by means of the following steps:

      - filtering of the intermediate-frequency or baseband signal (E31, E32) of all or part of the spectrum of the signal arriving from the satellite or from the mobile;
      - calculation (E33) of the rms voltage of the received radiofrequency signal;
      - filtering (E34) of this rms voltage;
      - calculation of the logarithm of this filtered rms voltage;

   - harmonic decomposition (E4) over each period of the power thus determined into a fundamental component (H1) and at least one harmonic component;
   - estimation (E5) of the angular misalignment x from the ratio between the fundamental component and a harmonic component.

2. The method according to claim 1, wherein the harmonic component of interest is the harmonic component 2 (H2), the estimation of the angular misalignment x being obtained from the ratio of the fundamental component to the harmonic component 2.

3. The method according to any of the preceding claims, wherein the movement is like a sinusoid or a 2D-composition of elementary movements on 2 orthogonal axes, of sinusoidal preferably elliptical or Lissajous types.

4. A method for tracking the pointing of an antenna, comprising a step of estimating the angular misalignment of the antenna by means of an estimation method according to any of claims 1 to 3, the method comprising a step of comparing (E6) the misalignment to a threshold (S1); and if the misalignment is greater than said threshold, the method comprising a step of stopping (E7) the transmission of the antenna towards the satellite or the mobile if the antenna is also a transmitting antenna.

5. The method for tracking the pointing of an antenna according to claim 4, comprising a step of comparing (E9) the harmonic 2 (H2) with two threshold values (S2, S3), and if said harmonic 2 (H2) is comprised between said two threshold values, the method comprising a step of generating (E10) an instruction to move the antenna in order to cancel the estimated misalignment.

6. A device for accurately measuring the angular misalignment of an antenna comprising a processor configured to implement a method according to any of claims 1 to 3.

7. A device for tracking the pointing of an antenna comprising a unit (2) for controlling the antenna (1) and a device for estimating the angular misalignment of the antenna according to claim 8 comprising a processor configured to implement a method according to any of claims 4 to 5.

FIG. 1

FIG. 2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6433736 B
- US 7633432 B
- US 2638585 A